(19) Europäisches Patentamt
European Patent Office
Office européen des brevets

(11) **EP 1 927 174 B1**

(12) **EUROPEAN PATENT SPECIFICATION**

(45) Date of publication and mention
of the grant of the patent:
**06.03.2013 Bulletin 2013/10**

(51) Int Cl.:
*H01L 27/02* (2006.01)   *H03F 1/22* (2006.01)
*H03F 1/52* (2006.01)   *H03F 3/60* (2006.01)

(21) Application number: **06814981.4**

(86) International application number:
**PCT/US2006/036552**

(22) Date of filing: **19.09.2006**

(87) International publication number:
**WO 2007/035777 (29.03.2007 Gazette 2007/13)**

(54) **ESD PROTECTION CIRCUITS**

ESD-SCHUTZSCHALTUNGEN

CIRCUITS DE PROTECTION CONTRE LES DÉCHARGES ÉLECTROSTATIQUES

(84) Designated Contracting States:
**DE FR GB**

(30) Priority: **19.09.2005 US 718965 P**
**19.09.2005 US 718967 P**

(43) Date of publication of application:
**04.06.2008 Bulletin 2008/23**

(73) Proprietor: **The Regents of The University of California**
**Oakland, CA 94607-5200 (US)**

(72) Inventors:
• **MA, Yintat**
**Corona, CA 92880-3469 (US)**

• **LI, Guann-Pyng**
**Irvine, California 92612 (US)**

(74) Representative: **Charig, Raymond Julian**
**Potter Clarkson LLP**
**The Belgrave Centre**
**Talbot Street**
**Nottingham NG1 5GG (GB)**

(56) References cited:
| | |
|---|---|
| US-A- 5 028 977 | US-A- 5 550 699 |
| US-A- 6 069 782 | US-A1- 2001 015 881 |
| US-A1- 2002 154 463 | US-A1- 2003 231 441 |
| US-A1- 2004 212 936 | US-B1- 6 459 340 |

**Description**

FIELD OF THE INVENTION

The present disclosure relates to low capacitance loading electrostatic discharge (ESD) protection circuits and, more particularly, to ESD protection circuits for use as on-chip voltage overload protection circuits for power amplifiers, on-chip ESD protection circuits for RF input pins for integrated circuits such as telecom circuits, and unit protection cells for integration with artificial transmission lines of distributed amplifiers.

BACKGROUND

The collector output of an RF power amplifier is usually connected with a RF inductor, often referred to as the RF choke, and an output impedance matching network. The other side of the output impedance matching network is terminated with a termination, such as an antenna. The voltage at the transistor collector output is described by $Vo = Vs + L\dfrac{di}{dt}$. As a result, the voltage at the transistor collector output can be higher than the supply voltage. Furthermore, how high this voltage would be also depends on the impedance of the output impedance matching network. In an output impedance mismatch condition, such as in cases of a loose or obstructed antenna, the reflected signal reflects back to the transistor and produces a large voltage waveform so severe that the transistor junctions can be damaged. Furthermore, the power amplifier, due to the requirement of delivering high output power with high efficiency, often operates at an overdrive condition in which the transistor input voltage is so high that it switches on and off the collector current.

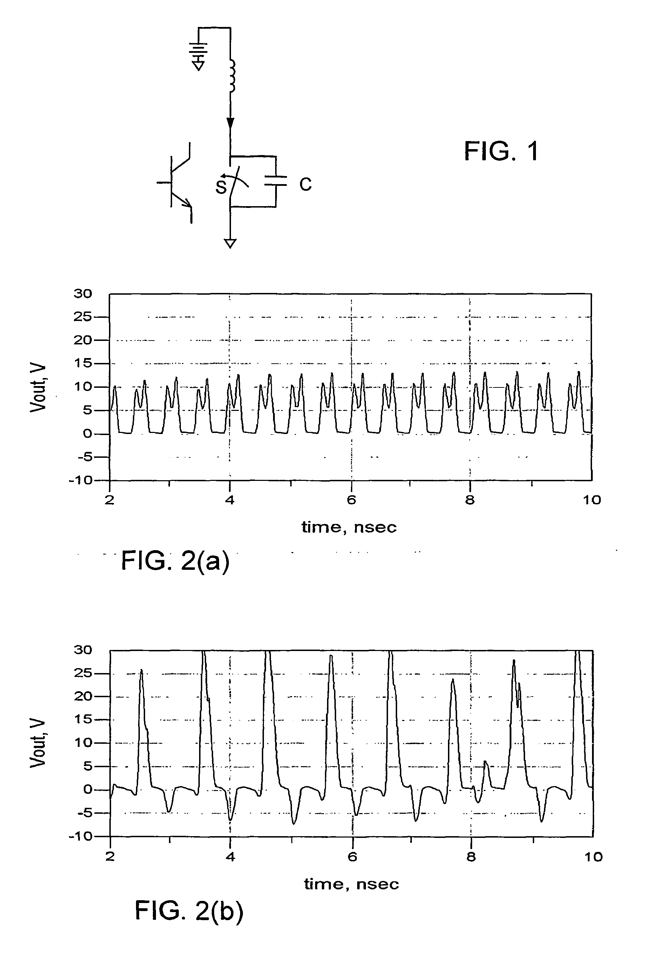

During overdrive, the transistor can be modeled as a switch S in parallel with a capacitor C as shown in Fig. 1. When the switch S is shorted, the current through the inductor is at a maximum. As soon as the switch S is opened, since the inductor current cannot be zero instantaneously, the inductor current flows to the transistor capacitance and the output impedance network. Because of an enormous inductor current, the transient voltage at the collector output can be very high. This excessive voltage overload can lead to device failure and degradation in reliability if it is higher than the breakdown voltages.

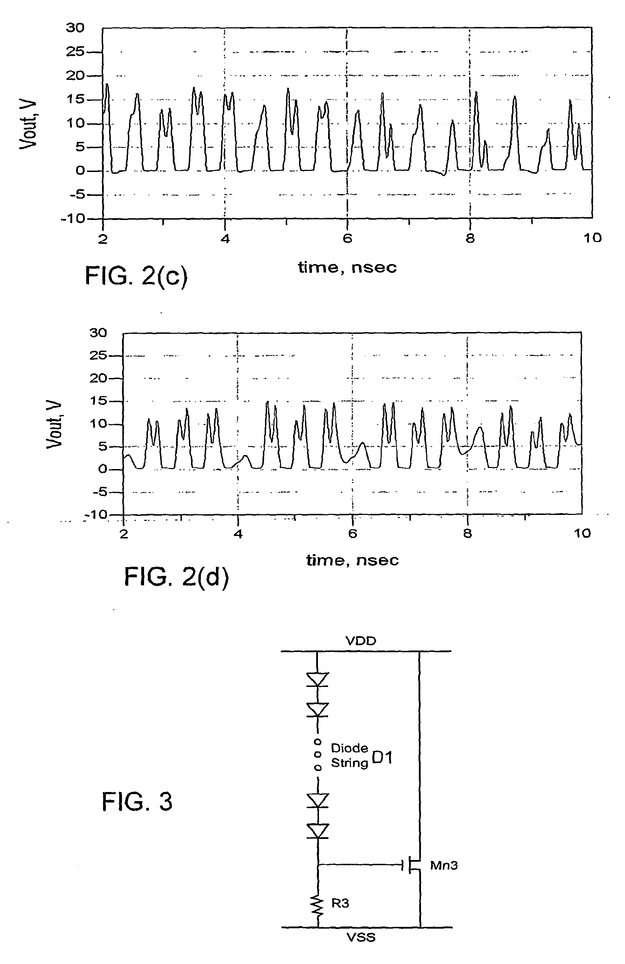

Even when the output termination impedance is 50 ohm, the transient collector output voltage waveform during RF overdrive can be larger than the breakdown voltage as shown in Fig. 2a. Since the excess voltage as shown is positive, the C-E and C-B junction are vulnerable. Output impedance mismatch and modulated input signal combined with overdrive can make the voltage overload more severe. For an open termination, such as the case when an antenna is not connected, combined with RF overdrive, the output voltage is the most severe as shown in Fig. 2b. The transient output voltage is so large that it even goes negative in which case the E-B junction is also vulnerable. For a shorted termination combined with RF overdrive, although the voltage overload is not as severe as the open termination, it is still more severe, as shown in Fig. 2c, than a 50 ohm case. Modulation of the input signal can add additional transient output voltage. With just a simple AM modulation with a pulse train combined with RF overdrive, the voltage overload gets even worse as shown in Fig. 2d. For a multiple stage amplifier, the voltage overload at the output stage can be even worse if the driver stages are overdriven, since the voltage spikes of the driver stages would be amplified by the output stages. Usually, the transistor failures due to voltage overload occurs at the output stage, but they can also occur at the driver stages.

The function of a voltage overload protection circuit is to clamp the excess voltage to a safe level and bypass the overload current away from the transistor. This voltage clamp design should take into consideration the voltage swing of the signal so the operation of the power amplifier is not interfered. The voltage overload protection circuit should have low loading capacitance, so the RF performance is not affected.

An ESD protection circuit shown in Fig. 3, which can be used as a voltage overload protection circuit, is designed as a VDD to VSS clamp circuit for CMOS. [Ker, 2001.] To avoid the diode leakage problem associated with un-isolated diodes, the diode is selected doped on a field oxide. This design uses a diode string (D1) to trigger the NMOS (Mn3). The voltage across R3 turns on Mn3. An example of this circuit can be found in patent application US 6,069,782.

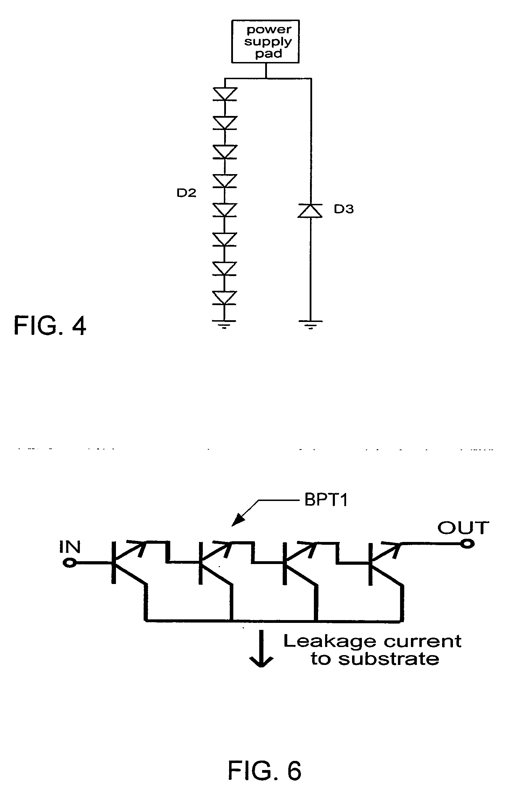

An ESD protection circuit using a diode string shown in Fig. 4, which can be used as a voltage overload protection circuit, is popular in GaAs HBT design and is commonly used. Because diodes on GaAs are made with epi layers either of MOVCD or MBE, they do not have current leakage problem associated with implanted diodes for Silicon.

When a positive voltage is applied to a PAD (Fig. 4), the diode string (D2) is turned on. The overload current then sinks through the string of diodes. The number of diodes determines the preset voltage that turns on the diodes. When a negative voltage is applied to the PAD, the reverse diode (D3) turns on and sinks the overload current. Because of the series resistance of the diodes, the required area of the diodes is huge. This, in turn, increases the diode capacitance, which can limit the frequency bandwidth.

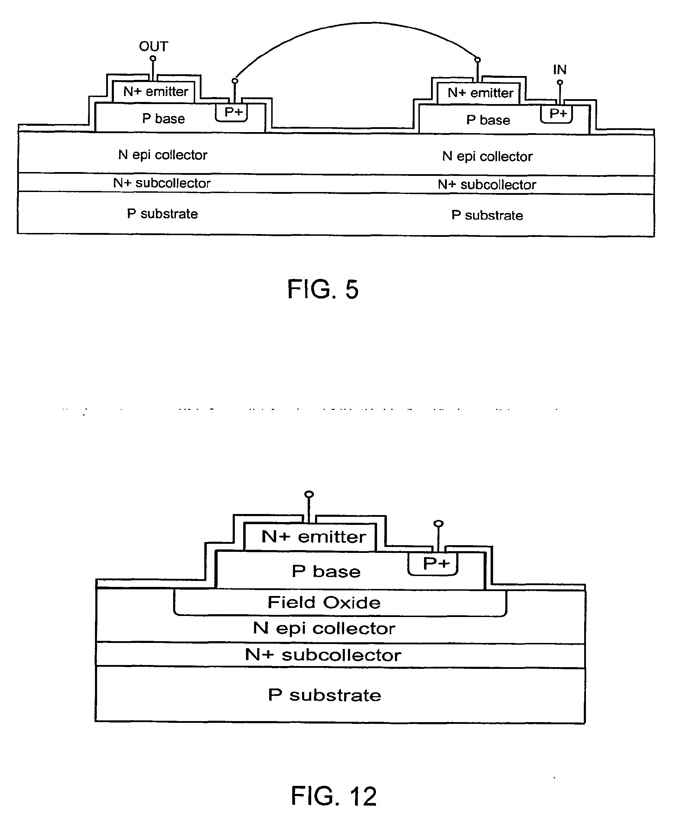

In the case of SiGe, the implanted diode string without isolation, shown in Fig. 5, is actually a set of bipolar transistors (BPT1) in series as shown in Fig. 6. As the temperature increases, the leakage current from the collector to substrate increases. Because of this current leakage, the latter stages have lower current density due to current flow to ground. This results in declining incremental voltage drop across the diode string. Therefore, the diode should be isolated.

ESD protection of an RF input pin of integrated circuits, such as a telecom integrated, circuit can be difficult. The operation voltage at the RF input pin is low, so the turn on voltage of the ESD protection circuit must be low. Even so, for the RF input pin ESD protection, the base-emitter junction at the RF signal input must turn on first during the ESD event before the ESD protection circuit. The ESD protection circuit can only turn on when the base voltage becomes sufficiently high which is permitted thanks to a base-emitter resistance drop.

Because of this inherent problem, the base-emitter always has to endure some amount of ESD stress before the protection circuit turns on. For this reason, ESD voltage protection for the RF input pin is more difficult.

Furthermore, the input ESD protection circuit needs to limit excessive forward base-emitter current during ESD stress. Using a 2-diode string ESD protection circuit would work without introducing a significant resistance voltage drop problem associated with the large number of series diodes in diode strings typically used at the RF output and DC pin. Simulation also shows that a 2-diode string would have low capacitance and low turn on resistance. However, since a two-diode string has a low turn on voltage due to a lower number of diodes, its leakage current is greater if the input voltage swing is large. A 2-diode string, due to its low turn on voltage, has a significant leakage current when the input RF power is more than 10dBm and worse linearity (2 tone 3rd order inter-modulation products).

Distributed amplifiers have very wide bandwidths due to their transmission line characteristics. However, when ESD protection circuits are added to a distributed amplifier, the capacitance loading of the ESD protection circuits can degrade the bandwidth of the distributed amplifier.

There is therefore a need for an improved ESD protection circuit for use as an overload protection circuit for power amplifiers, an ESD protection circuit for RF input pins for integrated circuits such as telecom circuits, and unit protection cells for a distributed amplifier.

SUMMARY

The embodiments disclosed herein provide on-chip ESD protection circuits for RF input pins for integrated circuits such as telecom integrated circuits, and unit protection cells for integration with artificial transmission lines of distributed amplifiers. In one embodiment, an overload protection circuit includes a positive threshold voltage trigger used to trigger a switch. The switch preferably comprises a bipolar transistor switch in series with a single reverse diode.

The voltage trigger is used to trigger a Darlington pair transistor switch in series with a single reverse diode. The Darlington pair transistor switch comprises a first transistor in series with a second transistor. In each embodiment, the reverse diode can be used for clamping excess negative overload voltage.

The voltage overload protection circuit is very fast and preferably faster than the power amplifier. Preferably, the voltage trigger is turned on in less than 20 psec. In a preferred embodiment, the diode is an isolated implanted diode.

The overload protection circuit preferably has less parasitic capacitance than a conventional diode string approach for an overload protection circuit. From simulation, conventional circuits have been shown to have twice the parasitic capacitance as the overload protection circuit provided herein with similar overload protection performance. Further, the overload protection circuit of the present invention occupies one forth of the area and has one half the capacitance of a conventional diode string approach for an ESD protection circuit. The smaller size is due to the Darlington pair being more efficient for conducting excess current. Because of less capacitance, the overload protection circuit provided herein can enhance the circuit performance of the main circuit at higher frequency.

In an embodiment of an ESD protection circuit for use as an on-chip ESD protection circuit of RF input pins for integrated circuits such as telecom integrated circuits. The ESD protection circuit preferably includes a Darlington transistor switch triggered by a capacitor. In a preferred embodiment, the Darlington transistor switch preferably has 2 or 3 transistors.

During an ESD event, ESD is coupled across the capacitor and turns on the Darlington switch. Since the Darlington switch has high current gain, only a small amount of input ESD current is needed to trigger the Darlington switch, thus resulting in a small size for the trigger capacitor. The trigger capacitor also has the benefit of blocking the DC current, reducing the leakage current at high power, improving linearly and lowering the overall capacitance loading.

The embodiments disclosed herein provide a improved ESD protection circuit for distributive amplifiers wherein the ESD protection circuits are absorbed inside the artificial transmission lines of the distributed amplifier. In this scheme, since ESD protection circuits are distributed in every transistor stage, the capacitance of the ESD protection circuit is absorbed and becomes part of the capacitance used for forming the artificial transmission lines. Since there are more ESD protection circuits, the size of each current switch (Darlington pair) can be reduced in size to obtain lower capacitance.

Further, objects and advantages of the invention will become apparent from the following detailed description and accompanying drawings.

BRIEF DESCRIPTION OF THE FIGURES

The details of the invention, including fabrication, structure and operation, may be gleaned in part by study of the accompanying figures, in which like reference numerals refer to like segments.

Fig. 1 is a schematic of a transistor modeled as a switch for RF overdrive.

Fig. 2 is a graphical representation of a simulated voltage waveform at the collector output for a WCDMA power amplifier during RF overdrive when output termination is (a) 50 ohm, (b) open, (c) short, and (d) 50 ohm and the input signal is AM modulated with pulses.

Fig. 3 is a schematic of a VDD to VSS clamp circuit.

Fig. 4 is a schematic of an on-chip voltage overload protection circuit using all diodes.

Fig. 5 is a cross-sectional view of a diode string in p-substrate SiGe.

Fig. 6 is a schematic of an implanted diode string without isolation in p-substrate SiGe.

Fig. 7 is a schematic block diagram of a voltage overload protection circuit.

Fig. 8 is a schematic of an on-chip voltage overload protection circuit using single bipolar transistor switch.

Fig. 9 is a schematic of an on-chip voltage overload protection circuit using Darlington pair switch.

Fig. 10 is a graphical representation of a simulated collector output voltage waveform during RF overdrive when output termination impedance is 50 ohm and the collector output is connected (a) with (solid) and (b) without (dot) voltage overload protection circuit.

Fig. 11 is a close up view of Fig. 10.

Fig. 12 is cross-sectional view of an isolated implanted diode using base emitter junction for SiGe.

Fig. 13 are schematics of capacitor triggered Darlington switch ESD protection circuits for RF input pin using Darlington switch of (a) two transistors and (b) three transistors.

Fig. 14 is a graphical representation showing (a) simulated DC leakage current of ESD protection circuits and (b) simulated RF leakage current of ESD protection circuits.

Fig. 15 is a graphical representation showing simulated 2 tone 3rd order inter-modulation product of the ESD protection circuits.

Fig. 16 is a schematic of broadband distributed amplifiers with a single ESD protection circuit at each pin.

Fig. 17 is a schematic of a broadband distributed amplifier with ESD protection circuits absorbed by the artificial transmission lines.

Fig. 18 includes a graphical representation showing a comparison of simulated transimpedance of a distributed amplifier without ESD protection circuits and with ESD protection circuits, either with a single ESD protection circuit at each RF pin or with ESD protection circuits absorbed by the artificial transmission lines.

It should be noted that the figures are not drawn to scale and that elements of similar structures or functions are generally represented by like reference numerals for illustrative purposes throughout the figures. It also should be noted that the figures are only intended to facilitate the description of the preferred embodiments.

DETAILED DESCRIPTION

Each of the additional features and teachings disclosed below may be utilized separately or in conjunction with other features and teachings to provide ESD protection circuits for use as on-chip voltage overload protection circuits for power amplifiers, on-chip ESD protection circuits for RF input pins for integrated circuits such as telecom integrated circuits, and unit protection cells for integration with artificial transmission lines of distributed amplifiers. Representative examples of the present invention, which examples utilize many of these additional features and teachings both separately and in combination, will now be described in further detail with reference to the attached drawings. This detailed description is merely intended to teach a person of skill in the art further details for practicing preferred aspects of the present teachings and is not intended to limit the scope of the invention. Therefore, combinations of features and steps disclosed in the following detail description may not be necessary to practice the invention in the broadest sense, and are instead taught merely to particularly describe representative examples of the present teachings.

Moreover, the various features of the representative examples and the dependent claims may be combined in ways that are not specifically and explicitly enumerated in order to provide additional useful embodiments of the present teachings. In addition, it is expressly noted that all features disclosed in the description and/or the claims are intended to be disclosed separately and independently from each other for the purpose of original disclosure, as well as for the purpose of restricting the claimed subject matter independent of the compositions of the features in the embodiments and/or the claims. It is also expressly noted that all value ranges or indications of groups of entities disclose every possible intermediate value or intermediate entity for the purpose of original disclosure, as well as for the purpose of restricting the claimed subject matter.

The embodiments disclosed herein provide low loading capacitance on-chip ESD protection circuits for use as voltage overload protection circuits for power amplifiers at output impedance mismatch, RF overdrive, and modulated input signal conditions, as ESD protection circuits for RF input pins of integrated circuits such as telecom integrated circuits, unit protection cells to be integrated with artificail transmission lines for broadband amplifiers such as distributed amplifiers without degrading their performance. A low loading capacitance on-chip ESD protection circuit for telecom integrated circuits implemented by heterojunction bipolar transistor technology is described in U.S. provisional patent application serial no. 60/349,899, filed on Jan. 18, 2002, which is incorporated herein by reference.

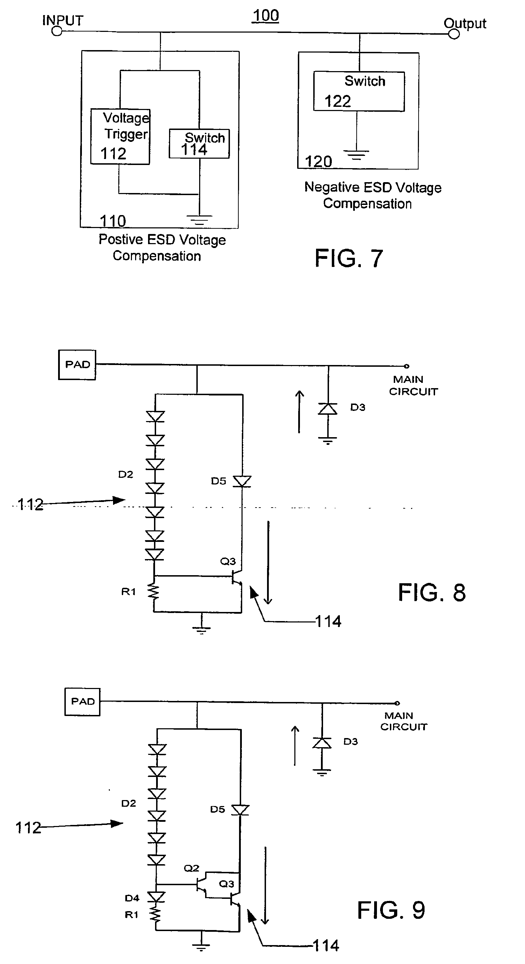

Turning to Fig. 7, as depicted, an overload protection circuit 100 preferably includes positive and negative overload voltage compensation blocks 110 and 120 respectively. The positive compensation block 110 preferably includes a voltage trigger 112 and a switch 114. The negative compensation block 120 preferably includes a switch 122.

Referring to Fig. 8, the overload protection circuit includes a positive threshold voltage trigger 112, which preferably comprises a diode string D2 in series with a single resistor R1. The trigger 112, which is coupled to a switch 114, is used to trigger the switch 114. As depicted, the switch 114 is preferably a bipolar transistor switch Q3 in series with a single diode D5.

Referring to Fig. 9, the positive threshold voltage trigger 112 preferably comprises a diode string D2 in series with a single diode D4 and a single resistor R1. The voltage trigger 112 is preferably coupled to and used to trigger a Darlington pair transistor switch 114 in series with a single diode D5. The Darlington pair transistor switch 114 preferably comprises a first transistor Q2 in series with a second transistor Q3. Where the same circuit provides both ESD and voltage overload protection, the number of diodes can be carefully selected to determine the appropriate turn on voltage and the level of overload voltage that can be protected.

The reverse diode D3, shown in both Fig. 8 and Fig. 9, can be used for clamping excess negative overload voltage.

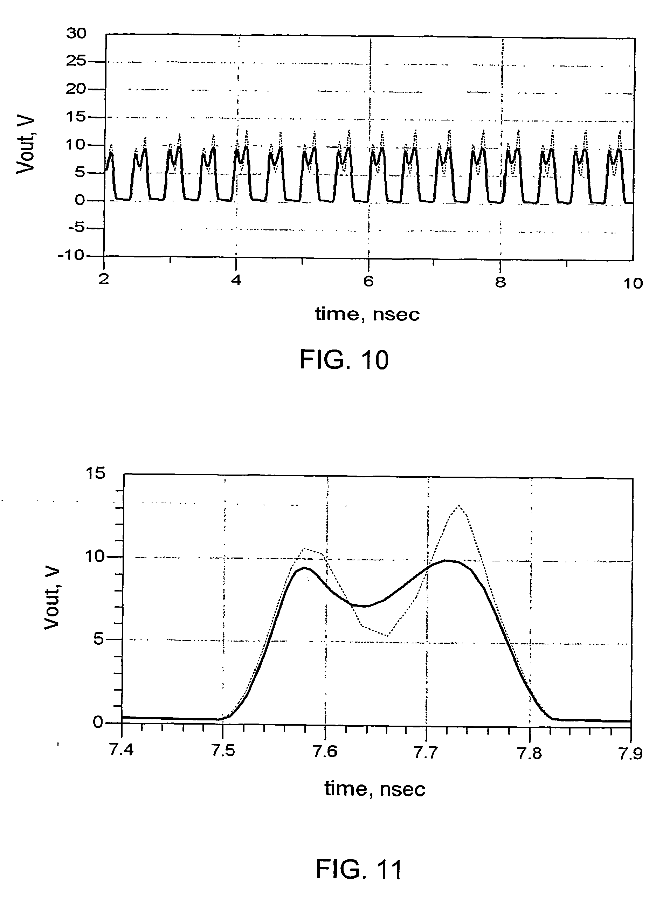

Fig. 10 (solid line) shows the transistor output waveform with the voltage overload protection circuit clamping the excess voltage. During a voltage overload event, such as in a condition of an output impedance mismatch, a RF overdrive and/or a modulated input signal condition, the overload current is coupled across the diode string D2 of the trigger and turns on the switch. The turn on time of the voltage overload protection circuit is very fast, less than 20 psec, as shown in Fig. 11.

To protect the SiGe HBT power amplifiers, the same protection circuit topology as shown in Figs. 8 and 9 can be implemented. Since SiGe HBT has a lower breakdown than GaAs HBT, the voltage overload protection circuit is very important for improving reliability of SiGe HBT power amplifiers. In addition to GaAs and SiGe power amplifier process technologies, the overload protection circuit topology as shown in Figs. 8 and 9 can be implemented with power amplifier process technologies of Silicon bipolar, CMOS and the like.

In a preferred embodiment, as shown in Fig. 12, the diode is an isolated implanted diode. The isolated implanted diode is constructed advantageously using conventional processes.

The diode string triggered overload protection circuits shown in Figs. 8 and 9 advantageously work as ESD protection circuits for the RF output pin and the DC pin, where the voltage swing and operation voltage are high. However, as noted above, ESD protection circuits used to protect RF input pins need to meet additional challenges.

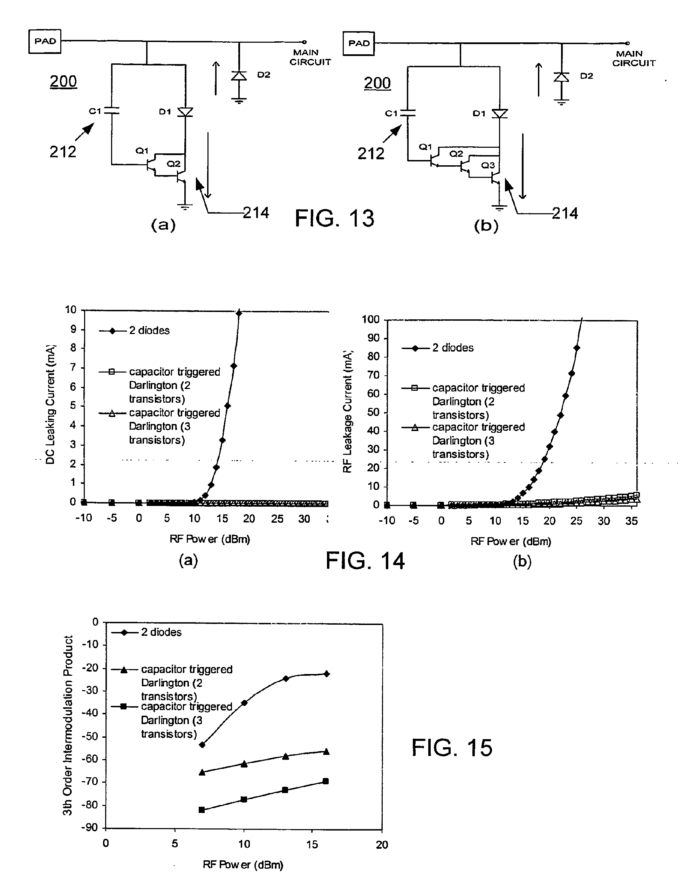

An ESD protection circuit 200 for a RF input pin is shown in Fig. 13. The circuit 200, which includes a Darlington pair transistor switch 214 comprising a first transistor Q1 in series with a second transistor Q2, is modified by replacing the triggering diode string shown in Figs. 8 and 9 with a capacitor C1. The capacitor C1 serves as a trigger 212 for the transistor switch 214, which is in series with a single diode D1. During an ESD event, the ESD current is coupled across the capacitor C1 and turns on the Darlington pair 214. Since the Darlington pair 214 has high current gain, only a small amount of input ESD current is needed to trigger the Darlington pair 214, thus resulting in a small size for the trigger capacitor C1 212. The capacitor C1 also has the benefit of blocking the DC current, reducing the leakage current at high power, improving linearly and lowering the overall capacitance loading. Although the circuit does not necessarily have to be connected directly to a pad, since ESD is transmitted from outside of the circuit, usually via a pad, the ESD protection circuit can provide ESD protection at the pad.

For the Darlington switch 214, it preferably comprises either 2 transistors Q1 and Q2 mounted in series, as depicted in Fig. 13a, or 3 transistors mounted in series Q1, Q2 and Q3, as depicted in Fig. 13b. Measurements have shown that the two-transistor Darlington switch offers better ESD protection, but the three-transistor Darlington switch has less capacitance. As confirmed in Fig. 14a and Fig. 14b, the DC and RF leakage current of the capacitor triggered Darlington pair ESD protection circuits are lower than those of a 2-diode ESD protection circuit. Furthermore, the capacitor triggered Darlington pair ESD protection circuits have better linearity as shown in Fig. 15.

The reverse diodes D3 and D2, shown in both Figs. 8, 9 and 13, respectively, can be used for clamping excess negative voltage.

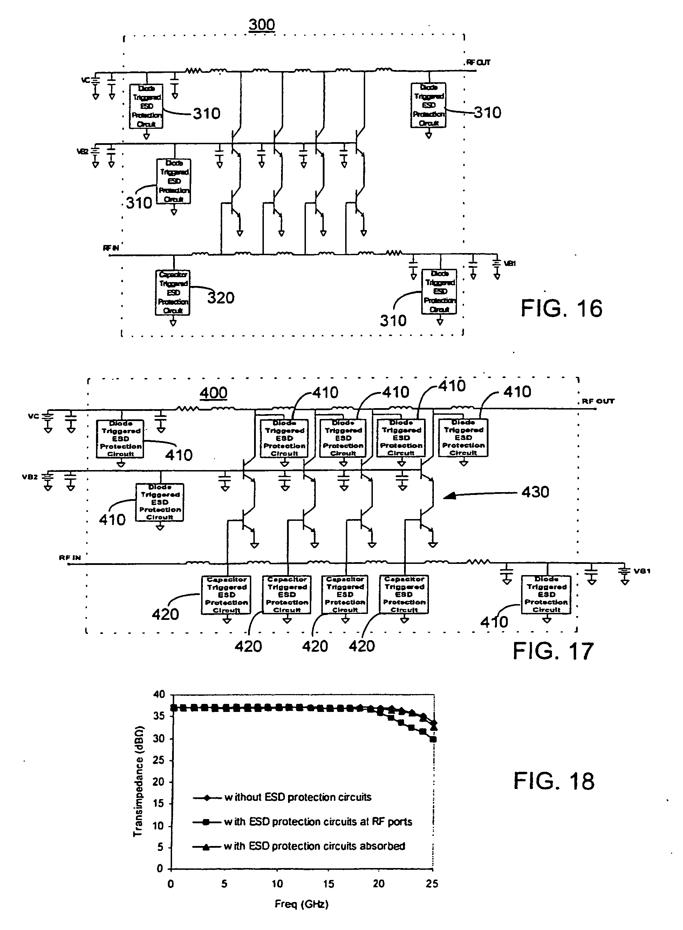

A distributed amplifier has very wide bandwidth due to its transmission line characteristic. However, when ESD protection circuits 310 are added to a distributed amplifier 300 as shown in Fig. 16, the capacitance loading of the ESD protection circuits 310 can degrade the bandwidth of a distributed amplifier 300. To improve ESD robustness with minimum degradation in bandwidth, ESD protection circuits 410 and 420 can be absorbed inside the artificial transmission lines of the distributed amplifier 400 as shown in Fig. 17. In this scheme, since ESD protection circuits 410 are distributed in every transistor stage 430, the capacitance of the ESD protection circuit 410, 420 is absorbed and becomes part of the capacitance used for forming the artificial transmission lines. With distributed ESD protection, one big ESD protection circuit can advantageously be divided into more than one smaller circuit with the capacitance of each ESD protection circuit absorbed into each stage. Since are more ESD protection circuits, the size of each, and of each current switch (Darlington, can be reduced. Even with the same total capacitance or even larger, the capacitance loading to the distributed amplifier is less since the capacitance loading is absorbed. The distributed ESD scheme can be applied to other non-Darlington ESD protection circuits.

As depicted in Fig. 17, the preferred embodiment of a distributed amplifier 400 with ESD protection comprises a collector voltage pin VC, an RF output pin RF OUT, an RF input pin RF IN, a first base voltage pin VB1, a second base voltage pin VB2, and a plurality of transistor stages 430. The amplifier 400 preferably includes a diode triggered ESD protection circuit 410 at pins VC, VB1 and VB2, and ESD protection circuits distributed at each transistor stage 430. Preferably, a diode triggered ESD protection circuit 410 is distributed at each transistor stage in parallel with the upper transistor stage along the output transmission line and a capacitor triggered ESD protection circuit 420 is distributed at each stage in parallel with the lower transistor stage along the input transmission line.

For the output line, the diode string turns on the Darlington once the ESD voltage exceeds the turn on voltage of the diode string. An alternative ESD protection circuit is needed to meet an additional challenge for the RF input port protection. For the RF input port ESD protection, the base-emitter junction at the RF signal input turns on during the ESD event. That is, the ESD protection circuit only turns on when the base voltage becomes sufficiently high, due to base-emitter resistance drop. Because of this inherent problem, the base-emitter has to endure some amount of ESD stress before the protection circuit turns on. For this reason, ESD voltage protection for the input is more difficult The input ESD protection circuit needs to limit excessive forward base-emitter current during ESD stress. For this reason, an ESD protection circuit with a Darlington pair triggered by a capacitor is used. During an ESD event, ESD is coupled across the capacitor and turns on the Darlington pair. The capacitor also has the benefit of blocking the DC current, reducing the leakage current at high power, and lowering the overall capacitance loading.

For a distributed amplifier, the overall bandwidth is determined by the bandwidth of each transistor stage. Since the capacitance loading of all the ESD protection circuits is divided, only a fraction of this capacitance loading would affect the bandwidth. This results in improved bandwidth over the case with only a single large ESD protection circuit at each RF pin. Fig. 18 compares the simulated trans-impedance of a distributed amplifier without ESD protection circuits, with a single ESD protection circuit at each RF pin, and with ESD protection circuits distributed among each stage and its capacitance being absorbed by the artificial transmission lines. As shown in Fig. 18, for the same level of ESD protection, there is significantly less bandwidth degradation when the ESD protection circuits are distributed along the artificial transmission lines.

Turning back to Figs. 8, 9 and 13 exemplary embodiments of diode triggered and capacitor triggered ESD protection circuits are shown. In Fig. 8 the diode triggered ESD protection circuit includes a positive threshold voltage trigger, which comprises a diode string D2 in series with a single resistor R1. The trigger is used to trigger a bipolar transistor switch Q3 in series with a single diode D5. In Fig. 9 the positive threshold voltage trigger comprises a diode string D2 in series with a single diode D4 and a single resistor R1. The voltage trigger is used to trigger a Darlington pair transistor switch in series with a single diode D5. The Darlington pair transistor switch comprises a first transistor Q2 in series with a second transistor Q4. For the same circuit providing both ESD and voltage overload protection, the number of diodes can be carefully selected.

A capacitor triggered ESD protection circuit is shown in Fig. 13. The circuit, which preferably includes a Darlington pair transistor switch comprising a first transistor Q1 in series with a second transistor Q2, is modified by replacing the triggering diode string shown in Figs. 8 and 9 with a capacitor C1. The capacitor C1 serves as a trigger for the transistor switch.

In the foregoing specification, the invention has been described with reference to specific embodiments thereof. It will, however, be evident that various modifications and changes may be made thereto without departing from the scope of the invention as defined by the appended claims. For example, each feature of one embodiment can be mixed and matched with other features shown in other embodiments. Features and processes known to those of ordinary skill may similarly be incorporated as desired. Additionally and obviously, features may be added or subtracted as desired. Accordingly, the invention is not to be restricted except in light of the attached claims and their equivalents.

**Claims**

1. A capacitor-triggered ESD protection circuit (200) comprising
a capacitor-triggered positive voltage threshold trigger including a capacitor (C1),
a Darlington transistor switch (214) coupled at its base to the output of the positive voltage threshold trigger (C1), and
a diode (D1) coupled in series with the Darlington transistor switch (214), with the output of the diode coupled with the collector of the Darlington transistor switch, wherein an RF input pin is connected between the positive voltage threshold trigger (C1) and the diode (D1) along parallel paths to the input of the positive voltage threshold trigger and the input of the diode.

**2.** The circuit of claim 1 further including a reverse diode (D2) in parallel with the capacitor-triggered ESD protection circuit (200).

**3.** The circuit of claim 1 or claim 2 wherein the Darlington transistor switch (214) comprises first and second transistors (Q1, Q2).

**4.** A method of protecting a RF input pin during an ESD event, comprising the steps of
coupling an ESD current across a capacitor (C1) of a capacitor-triggered positive voltage threshold trigger of an ESD protection circuit,
turning on a Darlington transistor switch (214) coupled at its base to the output of the capacitor (C1) of the capacitor-triggered positive voltage threshold trigger, and
sinking the ESD current through the Darlington transistor switch and a diode (D1) coupled in series with the Darlington transistor switch with the output of the diode coupled with the collector of the Darlington transistor switch, wherein a RF input pin is connected between the positive voltage threshold trigger and the diode along parallel paths to the input of the capacitor of the positive voltage threshold trigger and the input of the diode.

**5.** The method of claim 4 wherein the Darlington transistor switch (214) comprises a first transistor (Q1) in series with a second transistor (Q2).

**6.** The method of claim 4 wherein the Darlington transistor switch is turned on in less than about 20 psec.

**7.** The method of claim 4 wherein the Darlington transistor switch (214) comprises first, second and third transistors (Q1, Q2, Q3) coupled in series.

**8.** The circuit of claim 1 wherein the Darlington transistor switch (214) comprises first, second and third transistors (Q1, Q2, Q3) coupled in series.

**9.** A distributed amplifier (300, 400) with ESD protection comprising
a plurality of artificial transmission lines,
a plurality of transistor stages (430) coupled in parallel between the plurality of artificial transmission lines, and
a plurality of ESD protection circuits (310, 320, 410, 420) distributed among the plurality of transistor stages and integrated into the plurality of artificial transmission lines,
wherein a plurality of the ESD protection circuits (310, 410) are diode triggered and individual ones of the plurality of diode-triggered ESD protection circuits are coupled in parallel with an upper transistor stage of the plurality of transistor stages along an output transmission line (RF OUT) and wherein a plurality of the ESD protection circuits (320, 420) are the capacitor-triggered ESD protection circuit of claim 1 and individual ones of the plurality of capacitor-triggered ESD protection circuits are coupled in parallel with a lower transistor stage of the plurality of transistor stages along an input transmission line (RFIN).

**10.** The amplifier of claim 9 further comprising a collector voltage pin (VC) and first and second base voltage pins (VB1, VB2), and ESD protection circuits (310, 320, 410, 420) distributed at each of the collector voltage and first and second base voltage pins.

**11.** The amplifier of claim 9 wherein the diode-triggered ESD circuit (310, 410) comprises a diode string (112) coupled to a switch (114).

**12.** The amplifier of claim 11 wherein the diode string (112) comprises a plurality of diodes.

**13.** The amplifier of claim 12 wherein the diode-triggered ESD circuit (310, 410) further comprises a resistor (R1) in series with the diode string.

**14.** The amplifier of claim 13 wherein the diode-triggered ESD circuit (310, 410) further comprises a diode (D4) in series with the resistor (R1) and the diode string $(D_2)$.

**15.** The amplifier of any one of claims 11-33 wherein the switch (114) of the diode-triggered ESD circuit is a bipolar transistor (Q3) switch.

**16.** The amplifier of any one of claims 11-14 wherein the switch (114) of the diode-triggered ESD circuit is a Darlington transistor switch (Q2, Q3).

**17.** The amplifier of claim 16 wherein the Darlington transistor switch of the diode-triggered ESD circuit comprises first and second transistors (Q2, Q3) in series.

**18.** The amplifiers of claim 9 wherein the Darlington transistor switch of the capacitor-triggered ESD protection circuit comprises first and second transistors (Q1, Q2) in series.

**19.** The amplifier of claim 9 wherein the Darlington transistor switch of the capacitor-triggered ESD protection circuit comprises first, second and third transistors (Q1, Q2, Q3) in series.

**20.** A distributed amplifier (300, 400) with ESD protection comprising
a collector voltage pin (VC),
an RF output pin (RF OUT),
an output transmission line coupling the RF output pin to the collector voltage pin,

an RF input pin (RF IN),
a first base voltage pin (VB1),
an input transmission line coupling the RF input pin to the first base voltage pin, a second base voltage pin (VB2) coupled to the collector voltage pin (VC), a plurality of transistor stages (430) distributed between the transmission lines,
a plurality of ESD protection circuits (320, 420) distributed among inputs of individual ones of the plurality of transistor stages, wherein each of the plurality of ESD protection circuits comprises a capacitor-triggered ESD protection circuit of claim 1, and a plurality of diode-triggered ESD protection circuits (310, 410) distributed at the collector voltage and first and second base voltage pins and at outputs of individual ones of the plurality of transistor stages.

21. The amplifier of claim 20 wherein the diode-triggered ESD protection circuits (310, 410) are distributed at each transistor stage in parallel with an upper transistor stage along the output transmission line.

22. The amplifiers of claim 20 wherein the capacitor-triggered ESD protection circuits (320, 420) are distributed at each transistor stage in parallel with a lower transistor stage along the input transmission line.

23. The amplifier of claim 21 wherein each of the diode-triggered ESD circuits (310, 410) comprises a diode string (112) coupled to a switch (114).

24. The amplifier of claim 22 wherein the diode string comprises a plurality of diodes (D2).

25. The amplifiers of claim 24 wherein each of the diode-triggered ESD circuits further comprises a resistor (R1) in series with the diode string (D2).

26. The amplifier of claim 25 wherein each of the diode-triggered ESD circuits further comprises a diode (D4) in series with the resistor (R1) and the diode string (D2).

27. The amplifier of any one of claims 23-25 wherein the diode-triggered ESD circuit switch is a bipolar transistor switch (Q3).

28. The amplifier of any one of claims 23-26 wherein the diode-triggered ESD circuit switch is a Darlington transistor switch (Q2, Q3).

29. The amplifier of claim 28 wherein the diode-triggered ESD circuit Darlington transistor switch comprises first and second transistors (Q2, Q3) in series.

30. The amplifier of claim 20 wherein the Darlington transistor switch comprises first and second transistors (Q1, Q2) in series.

31. The amplifier of claim 20 wherein the Darlington transistor switch comprises first, second and third transistors (Q1, Q2, Q3) in series.

**Patentansprüche**

1. Kondensator-getriggerte Schutzschaltung (200) gegen elektrostatische Entladung (ESD) mit:

   einem Kondensator-getriggerten Positivspannungsschwellwert-Trigger mit einem Kondensator (C1);
   einem Darlington-Transistor-Schalter (214), der mit seiner Basis mit dem Ausgang des Positivspannungsschwellwert-Triggers (C1) gekoppelt ist; und
   einer Diode (D1), die in Reihe mit dem Darlington-Transistor-Schalter (214) gekoppelt ist, wobei der Ausgang der Diode mit dem Kollektor des Darlington-Transistor-Schalters gekoppelt ist, wobei ein RF-Eingangspin zwischen den Positivspannungsschwellwert-Trigger (C1) und der Diode (D1) entlang von parallelen Wegen zu dem Eingang des Positivspannungsschwellwert-Triggers und dem Eingang der Diode verbunden ist.

2. Schaltung nach Anspruch 1, des Weiteren mit einer Rückwärtsdiode (D2) parallel mit der Kondensator-getriggerten ESD-Schutzschaltung (200).

3. Schaltung nach Anspruch 1 oder Anspruch 2, bei der die Darlington-Transistor-Schaltung (214) einen ersten und einen zweiten Transistor (Q1, Q2) umfasst.

4. Verfahren zum Schutz eines RF-Eingangspins während eines elektrostatischen Entladungsereignisses (ESD) mit den Schritten:

   Koppeln eines ESD-Stroms über einen Kondensator (C1) eines Kondensator-getriggerten Positivspannungsschwellwert-Triggers einer ESD-Schutzschaltung;
   Anschalten eines Darlington-Transistor-Schalters (214), der mit seiner Base mit dem Ausgang des Kondensators (C1) des Kondensator-getriggerten Positivspannungsschwellwert-Triggers gekoppelt ist; und
   Absenken des ESD-Stroms durch den Darlington-Transistor-Schalter und eine Diode (D1), die in Reihe mit dem Darlington-Transistor-Schalter gekoppelt ist, wobei der Ausgang der Diode mit dem Kollektor des Darlington-Transitor-Schalters gekoppelt ist, wobei ein RF-Eingangspin zwischen dem Positivspannungsschwellwert-Trigger und der Diode entlang von parallelen Wegen zu dem Eingang des Kondensators des Positivspannungsschwellwert-Triggers und dem Eingang der Diode verbunden ist.

5. Verfahren nach Anspruch 4, bei dem der Darlington-Transistor-Schalter (214) einen ersten Transistor (Q1) in Reihe mit einem zweiten Transistor (Q2) umfasst.

6. Verfahren nach Anspruch 4, bei dem der Darlington-Transistor in weniger als etwa 20 psek angeschaltet wird.

7. Verfahren nach Anspruch 4, bei dem der Darlington-Transistor-Schalter einen ersten, zweiten und dritten Transistor (Q1, Q2, Q3) umfasst, die in Reihe geschaltet sind.

8. Schaltung nach Anspruch 1, bei dem der Darlington-Transistor-Schalter (214) einen ersten, zweiten und dritten Transistor (Q1, Q2, Q3) umfasst, die in Reihe gekoppelt sind.

9. Verteilter Verstärker (300, 400) mit Schutz gegen elektrostatische Entladung (ESD) mit:

einer Mehrzahl von künstlichen Übertragungsleitungen;
einer Mehrzahl von Transistor-Stufen (430), die parallel zwischen der Mehrzahl von künstlichen Übertragungsleitungen gekoppelt sind; und
einer Mehrzahl von ESD-Schutzschaltungen (310, 320, 410, 420), die zwischen der Mehrzahl von Transistor-Stufen (430) verteilt und mit einer Mehrzahl von künstlichen Übertragungsleitungen integriert sind;
wobei die Mehrzahl der ESD-Schutzschaltungen (310, 410) Dioden-getriggert sind, und wobei Einzelne der Mehrzahl von Dioden-getriggerten ESD-Schutzschaltungen parallel mit einer oberen Transistorstufe der Mehrzahl von Transistorstufen entlang einer Ausgangsübertragungsleitung (RF OUT) geschaltet sind, und wobei eine Mehrzahl der ESD-Schutzschaltungen (320, 420) die Kondensator-getriggerten ESD-Schutzschaltung nach Anspruch 1 sind, und wobei Einzelne der Mehrzahl von Kondensator-getriggerten ESD-Schutzschaltungen parallel mit einer unteren Transistorstufe der Mehrzahl von Transistorstufen entlang einer Eingabeübertragungsleitung (RFIN) gekoppelt sind.

10. Verstärker nach Anspruch 9, des Weiteren mit einem Kollektorspannungspin (VC) und ersten und zweiten Basisspannungspins (VB1, VB2) und ESD-Schutzschaltungen (310, 320, 410, 420), die an jedem der Kollektorspannungs- und der ersten und zweiten Basisspannung-Pins verteilt sind.

11. Verstärker nach Anspruch 9, bei dem die Dioden-getriggerte ESD-Schaltung (310, 410) einen Diodenstring (112) umfasst, der mit einem Schalter (114) verbunden ist.

12. Verstärker nach Anspruch 11, bei dem der Diodenstring (112) eine Mehrzahl von Dioden umfasst.

13. Verstärker nach Anspruch 12, bei dem die Dioden-getriggerte ESD-Schaltung (310, 410) des Weiteren einen Widerstand (R1) in Reihe mit dem Diodenstring umfasst.

14. Verstärker nach Anspruch 13, bei dem die Dioden-getriggerte ESD-Schaltung (310, 410) des Weiteren eine Diode (D4) in Reihe mit dem Widerstand (R1) und dem Diodenstring (D2) umfasst.

15. Verstärker nach einem der Ansprüche 11 bis 13, bei dem der Schalter (114) der Dioden-getriggerten ESD-Schaltung ein Bipolar-Transistor-Schalter (Q3) ist.

16. Verstärker nach einem der Ansprüche 11 bis 14, bei dem der Schalter (114) der Dioden-getriggerten ESD-Schaltung ein Darlington-Transistor-Schalter (Q2, Q3) ist.

17. Verstärker nach Anspruch 16, bei dem der Darlington-Transistor-Schalter der Dioden-getriggerten ESD-Schaltung erste und zweite Transistoren (Q2, Q3) in Reihe umfasst.

18. Verstärker nach Anspruch 9, bei dem der Darlington-Transistor-Schalter der Kondensator-getriggerten ESD-Schutzschaltung erste und zweite Transistoren (Q1, Q2) in Reihe umfasst.

19. Verstärker nach Anspruch 9, bei dem der Darlington-Transistor-Schalter der Kondensator-getriggerten ESD-Schutzschaltung erste, zweite und dritte Transistoren (Q1, Q2, Q3) in Reihe umfasst.

20. Verteilter Verstärker (300, 400) mit gegen elektrostatische Entladung (ESD) mit:

einem Kollektorspannungspin (VC);
einem RF-Ausgangspin (RF OUT);
einer Ausgangsübertragungsleitung, die den RF-Ausgangspin mit dem Kollektorspannungspin koppelt;
einem RF-Eingangspin (RF IN),
einem ersten Basisspannungspin (VB1),
einer Eingangsübertragungsleitung, die den RF-Eingangspin mit dem ersten Basisspannungspin koppelt;

einem zweiten Basisspannungspin (VB2), der mit dem Kollektorspannungspin (VC) gekoppelt ist;

einer Mehrzahl von Transistorstufen (430), die zwischen den Übertragungsleitungen verteilt sind,

einer Mehrzahl von ESD-Schutzschaltungen (320, 420), die zwischen den Eingängen der Einzelnen der Mehrzahl von Transistorstufen verteilt sind, wobei jede der Mehrzahl von ESD-Schutzschaltungen eine Kondensator-getriggerte ESD-Schutzschaltung nach Anspruch 1 umfasst, und

einer Mehrzahl von Dioden-getriggerten ESD-Schutzschaltungen (310, 410), die an den Kollektorspannungs- und ersten und zweiten Basisspannungs-Pins und an den Ausgängen der jeweils einzelnen der Mehrzahl von Transistorstufen verteilt sind.

21. Verstärker nach Anspruch 20, bei dem die Dioden-getriggerten ESD-Schutzschaltungen (310, 410) auf jeder Transistorstufe parallel mit einer oberen Transistorstufe entlang der Ausgangsübertragungsleitung verteilt sind.

22. Verstärker nach Anspruch 20, bei dem die Kondensator-getriggerten ESD-Schutzschaltungen (320, 420) auf jeder Transistorstufe parallel mit einer unteren Transistorstufe entlang der Eingangsübertragungsleitung verteilt sind.

23. Verstärker nach Anspruch 21, bei dem jede der Dioden-getriggerten ESD-Schaltungen (310, 410) einen Diodenstring (112) umfasst, der mit einem Schalter (114) gekoppelt ist.

24. Vestärker nach Anspruch 22, bei dem der Diodenstring eine Mehrzahl von Dioden (D2) umfasst.

25. Verstärker nach Anspruch 24, bei dem jede der Dioden-getriggerten ESD-Schaltungen des Weiteren einen Widerstand (R1) in Reihen mit dem Diodenstring (D2) umfasst.

26. Verstärker nach Anspruch 25, bei dem jede der Dioden-getriggerten ESD-Schaltungen des Weiteren eine Diode (D4) in Reihe mit dem Widerstand (R1) und dem Diodenstring (D2) umfasst.

27. Verstärker nach einem der Ansprüche 23 bis 25, bei dem die Dioden-getriggerte ESD-Schaltung als Schalter einen Bipolar-Transistor-Schalter (Q3) aufweist.

28. Verstärker nach einem der Ansprüche 23 bis 26, bei dem die Dioden-getriggerten ESD-Schaltung als Schalter einen Darlington-Transistor-Schalter (Q2, Q3) umfasst.

29. Verstärker nach Anspruch 28, bei dem die Dioden-getriggerte ESD-Schaltung einen Darlington-Transistor-Schalter mit ersten und zweiten Transistoren (Q2, Q3) in Reihe umfasst.

30. Verstärker nach Anspruch 20, bei dem der Darlington-Transistor-Schalter erste und zweite Transistoren (Q1, Q2) in Reihe umfasst.

31. Verstärker nach Anspruch 20, bei dem der Darlington-Transistor-Schalter erste, zweite und dritte Transistoren (Q1, Q2, Q3) umfasst.

**Revendications**

1. Circuit de protection contre les décharges électrostatiques à déclenchement par condensateur (200) comprenant

un déclencheur à seuil de tension positive à déclenchement par condensateur comprenant un condensateur (C1),

un commutateur à transistors Darlington (214) couplé au niveau de sa base à la sortie du déclencheur à seuil de tension positive (C1), et

une diode (D1) couplée en série avec le commutateur à transistors Darlington (214), la sortie de la diode étant couplée avec le collecteur du commutateur à transistors Darlington, dans lequel une borne d'entrée RF est raccordée entre le déclencheur à seuil de tension positive (C1) et la diode (D1) le long de passages parallèles jusqu'à l'entrée du déclencheur à seuil de tension positive et l'entrée de la diode.

2. Circuit selon la revendication 1, comprenant en outre une diode opposée (D2) en parallèle avec le circuit de protection contre les décharges électrostatiques à déclenchement par condensateur (200).

3. Circuit selon la revendication 1 ou la revendication 2, dans lequel le commutateur à transistors Darlington (214) comprend des premier et deuxième transistors (Q1, Q2).

4. Procédé pour protéger une borne d'entrée RF pendant un évènement de décharge électrostatique, comprenant les étapes consistant à

coupler un courant de décharge électrostatique sur un condensateur (C1) d'un déclencheur à seuil de tension positive à déclenchement par condensateur d'un circuit de protection contre les décharges électrostatiques,

mettre en marche un commutateur à transistors Darlington (214) couplé à sa base à la sortie du condensateur (C1) du déclencheur à seuil de tension positive à déclenchement par condensateur, et

affaiblir le courant de décharge électrostatique par le biais du commutateur à transistors Darlington et une diode (D1) couplée en série avec le commutateur à transistors Darlington avec la sortie de la diode couplée avec le collecteur du commutateur à transistors Darlington, dans lequel une borne d'entrée RF est raccordée entre le déclencheur à seuil de tension positive et la diode le long de chemins parallèles, à l'entrée du condensateur du déclencheur à seuil de tension positive et l'entrée de la diode.

5. Procédé selon la revendication 4, dans lequel le commutateur à transistors Darlington (214) comprend un premier transistor (Q1) en série avec un deuxième transistor (Q2).

6. Procédé selon la revendication 4, dans lequel le commutateur à transistors Darlington est mis en marche en moins d'environ 20 psec.

7. Procédé selon la revendication 4, dans lequel le commutateur à transistors Darlington (214) comprend des premier, deuxième et troisième transistors (Q1, Q2, Q3) couplés en série.

8. Circuit selon la revendication 1, dans lequel le commutateur à transistors Darlington (214) comprend des premier, deuxième et troisième transistors (Q1, Q2, Q3) couplés en série.

9. Amplificateur à répartition (300, 400) avec une protection contre les décharges électrostatiques comprenant
une pluralité de lignes artificielles,
une pluralité d'étages de transistor (430) couplés en parallèle entre la pluralité de lignes artificielles, et
une pluralité de circuits de protection contre les décharges électrostatiques (310, 320, 410, 420) répartis parmi la pluralité d'étages de transistor et intégrés dans la pluralité de lignes artificielles,
dans lequel la pluralité de circuits de protection contre les décharges électrostatiques (310, 410) sont déclenchés par diode et les circuits individuels de la pluralité de circuits de protection contre les décharges électrostatiques à déclenchement par diode sont couplés en parallèle avec un étage de transistor supérieur de la pluralité d'étages de transistor le long d'une ligne de transmission de sortie (RF OUT) et dans lequel une pluralité de circuits de protection contre les décharges électrostatiques (320, 420) sont le circuit de protection contre les décharges électrostatiques à déclenchement par condensateur selon la revendication 1 et les circuits individuels de la pluralité de circuits de protection contre les décharges électrostatiques à déclenchement par condensateur sont couplés en parallèle avec un étage de transistor inférieur de la pluralité d'étages de transistor le long d'une ligne de transmission d'entrée (RFIN).

10. Amplificateur selon la revendication 9, comprenant en outre une borne de tension de collecteur (VC) et des première et seconde bornes de tension de base (Vβ1, Vβ2) et des circuits de protection contre les décharges électrostatiques (310, 320, 410, 420) répartis au niveau de chacune parmi la borne de tension de collecteur et les première et seconde bornes de tension de base.

11. Amplificateur selon la revendication 9, dans lequel le circuit de protection contre les décharges électrostatiques à déclenchement par diode (310, 410) comprend une chaîne de diodes (112) couplée à un commutateur (114).

12. Amplificateur selon la revendication 11, dans lequel la chaîne de diodes (112) comprend une pluralité de diodes.

13. Amplificateur selon la revendication 12, dans lequel le circuit de protection contre les décharges électrostatiques à déclenchement par diode (310, 410) comprend en outre une résistance (R1) en série avec la chaîne de diodes.

14. Amplificateur selon la revendication 13, dans lequel le circuit de protection contre les décharges électrostatiques à déclenchement par diode (310, 410) comprend en outre une diode (D4) en série avec la résistance (R1) et la chaîne de diodes (D2).

15. Amplificateur selon l'une quelconque des revendications 11 à 13, dans lequel le commutateur (114) du circuit de protection contre les décharges électrostatiques à déclenchement par diode est un commutateur à transistors bipolaires (Q3).

16. Amplificateur selon l'une quelconque des revendications 11 à 14, dans lequel le commutateur (114) du circuit de protection contre les décharges électrostatiques à déclenchement par diode est un commutateur à transistors Darlington (Q2, Q3).

17. Amplificateur selon la revendication 16, dans lequel le commutateur à transistors Darlington du circuit de protection contre les décharges électrostatiques à déclenchement par diode comprend des premier et deuxième transistors (Q2, Q3) en série.

18. Amplificateur selon la revendication 9, dans lequel le commutateur à transistors Darlington du circuit de protection contre les décharges électrostatiques à déclenchement par condensateur comprend des premier et deuxième transistors (Q1, Q2) en série.

19. Amplificateur selon la revendication 9, dans lequel le commutateur à transistor Darlington du circuit de protection contre les décharges électrostatiques à déclenchement par condensateur comprend des premier, deuxième et troisième transistors (Q1, Q2, Q3) en série.

20. Amplificateur à répartition (300, 400) avec une protection contre les décharges électrostatiques comprenant
une borne de tension de collecteur (VC),
une borne de sortie RF (RF OUT),
une ligne de transmission de sortie couplant la borne de sortie RF à la borne de tension de collecteur,
une borne d'entrée RF (RF IN),
une première borne de tension de base (Vβ1),
une ligne de transmission d'entrée couplant la borne d'entrée RF à la première borne de tension de base,
une seconde borne de tension de base (Vβ2) couplée à la borne de tension de collecteur (VC),
une pluralité d'étages de transistor (430) répartis entre les lignes de transmission,
une pluralité de circuits de protection contre les décharges électrostatiques (320, 420) répartis parmi les entrées des étages individuels de la pluralité d'étages de transistor, dans lequel chacun de la pluralité de circuits de protection contre les décharges électrostatiques comprend un circuit de protection contre les décharges électrostatiques à déclenchement par condensateur selon la revendication 1, et
une pluralité de circuits de protection contre les décharges électrostatiques à déclenchement par diode (310, 410) répartis au niveau des bornes de tension de collecteur et première et seconde bornes de tension de base et au niveau des sorties des étages individuels de la pluralité d'étages de transistor.

21. Amplificateur selon la revendication 20, dans lequel les circuits de protection contre les décharges électrostatiques à déclenchement par diode (310, 410) sont répartis à chaque étage de transistor parallèle à un étage de transistor supérieur le long de la ligne de transmission de sortie.

22. Amplificateur selon la revendication 20, dans lequel les circuits de protection contre les décharges électrostatiques à déclenchement par condensateur (320, 420) sont répartis à chaque étage de transistor en parallèle avec un étage de transistor inférieur le long de la ligne de transmission d'entrée.

23. Amplificateur selon la revendication 21, dans lequel chacun des circuits de protection contre les décharges électrostatiques à déclenchement par diode (310, 410) comprend une chaîne de diodes (112) raccordée à un commutateur (114).

24. Amplificateur selon la revendication 22, dans lequel la chaîne de diodes comprend une pluralité de diodes (D2).

25. Amplificateur selon la revendication 24, dans lequel chacun des circuits de protection contre les décharges électrostatiques à déclenchement par diode comprend en outre une résistance (R1) en série avec la chaîne de diodes (D2).

26. Amplificateur selon la revendication 25, dans lequel chacun des circuits de protection contre les décharges électrostatiques à déclenchement par diode comprend en outre une diode (D4) en série avec la résistance (R1) et la chaîne de diodes (D2).

27. Amplificateur selon l'une quelconque des revendications 23 à 25, dans lequel le commutateur de circuit de protection contre les décharges électrostatiques à déclenchement par diode est un commutateur à transistors bipolaires (Q3).

28. Amplificateur selon l'une quelconque des revendications 23 à 26, dans lequel le commutateur de circuit de protection contre les décharges électrostatiques à déclenchement par diode est un commutateur à transistors Darlington (Q2, Q3).

29. Amplificateur selon la revendication 28, dans lequel le commutateur à transistors Darlington du circuit de protection contre les décharges électrostatiques à déclenchement par diode comprend des premier et deuxième transistors (Q2, Q3) en série.

30. Amplificateur selon la revendication 20, dans lequel le commutateur à transistors Darlington comprend des premier et deuxième transistors (Q1, Q2) en série.

31. Amplificateur selon la revendication 20, dans lequel le commutateur à transistors Darlington comprend des premier, deuxième et troisième transistors (Q1, Q2, Q3) en série.

FIG. 1

FIG. 2(a)

FIG. 2(b)

FIG. 2(c)

FIG. 2(d)

FIG. 3

FIG. 4

FIG. 6

FIG. 5

FIG. 12

INPUT ○ ————————————— <u>100</u> ————————————— ○ Output

Voltage Trigger 112

Switch 114

110

Postive ESD Voltage Compensation

Switch 122

120

Negative ESD Voltage Compensation

## FIG. 7

PAD

MAIN CIRCUIT

D3

D2

D5

112

Q3

R1

114

## FIG. 8

PAD

MAIN CIRCUIT

D3

D2

D5

112

Q2

Q3

D4

R1

114

## FIG. 9

FIG. 10

FIG. 11

FIG. 13

FIG. 14

FIG. 15

FIG. 16

FIG. 17

FIG. 18

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6069782 A
- US 34989902 P